# EUROPÄISCHE PATENTANMELDUNG

(11) **EP 0 849 807 A1**
(43) Veröffentlichungstag der Anmeldung: **24.06.1998**
(21) Anmeldenummer: 97121520.7
(22) Anmeldetag: 06.12.1997
(51) Int. Cl.: H01L 29/872

(54) **Schottky-Diode**

(30) Priorität: 20.12.1996 DE 19653457
(71) Anmelder: General Semiconductor Ireland, Cork (IE)
(72) Erfinder: Igel, Günter, Dipl.-Ing., 79331 Teningen (DE)
(74) Vertreter: Hornig, Leonore, Dr.

(57) **Zusammenfassung**

Die Erfindung betrifft eine Schottky-Diode und ein Herstellungsverfahren einer Schottky-Diode. Auf dem Halbleitersubstrat 1 ist eine Isolierschicht (2) mit einer Öffnung (3) vorgesehen, die mit einer Schottky-Metallschicht (7) bedeckt sind, wobei in dem Halbleitersubstrat ein ringförmiger Halbleiterbereich (5) vorgesehen ist, der an die Isolatorschicht (2) und die Metallschicht (7) in einem den Metall-Isolatorübergang umgebenden Bereich angrenzt, wobei das Halbleitersubstrat 1 innerhalb der Öffnung (3) der Isolatorschicht (2) eine Vertiefung (6') aufweist, deren Fläche mit der Schottky-Metallschicht (7) bedeckt ist.

## Beschreibung

Die Erfindung betrifft eine Schottky-Diode mit einem Halbleitersubstrat eines ersten Dotierungstyps mit einer ersten Dotierungsdichte, auf dem eine Isolatorschicht mit einer Öffnung vorgesehen ist, und mit einer wenigstens einen Teil der Isolatorschicht und das unter der Öffnung liegende Halbleitersubstrat bedeckenden Schottky-Metallschicht, wobei in dem Halbleitersubstrat ein ringförmiger Halbleiterbereich eines zweiten Dotierungstyps mit einer zweiten Dotierungskonzentration, die höher als die erste Dotierungskonzentration ist, vorgesehen ist, der an die Isolatorschicht und Schottky-Metallschicht in einem den Metall-Isolatorübergang umgebenden Bereich angrenzt.

Ferner betrifft die Erfindung ein Verfahren zum Herstellen einer Schottky-Diode, bei dem auf einem Halbleitersubstrat eines ersten Dotierungstyps mit einer ersten Dotierungsdichte eine Isolatorschicht mit einer Öffnung vorgesehen wird, eine Schottky-Metallschicht auf wenigstens einen Teil der Isolatorschicht und auf das unter der Öffnung liegende Halbleitersubstrat aufgebracht wird, in das Halbleitersubstrat ein ringförmiger Halbleiterbereich eines zweiten Dotierungstyps mit einer zweiten Dotierungskonzentration, die höher als die erste Dotierungskonzentration ist, eingebracht wird, so daß der Halbleiterbereich an die Isolatorschicht und die Metallschicht in einem den Metall-Isolatorübergang umgebenden Bereich angrenzt.

Eine derartige Schottky-Diode wird auch Schottky-Hybrid-Diode genannt. Sie unterscheidet sich von einer gewöhnlichen Schottky-Diode dadurch, daß der ringförmige Halbleiterbereich des zweiten Dotierungstyps, auch Guard-Ring genannt, vorgesehen ist. Dieser Guard-Ring bewirkt, daß die Sperrspannung, die bei einer normalen Schottky-Diode sehr niedrig ist, wesentlich erhöht wird. Das Spannungsdurchbruchverhalten wird somit gegenüber der gewöhnlichen Schottky-Diode wesentlich verbessert. Dieser Effekt kommt dadurch zustande, daß das Randfeld der Metallelektrode, d.h. der Schottky-Metallschicht dadurch reduziert wird, daß es zumindest teilweise in dem ringförmigen Halbleiterbereich des zweiten Dotierungstyps mit der zweiten Dotierungskonzentration endet.

Eine derartige Schottky-Hybrid-Diode zeigt jedoch Nachteile, wenn sie in Flußrichtung geschaltet ist. Durch den Übergang zwischen der Schottky-Metallschicht und dem ringförmigen Halbleiterbereich entsteht eine zweite Schottky-Diode, die gegenüber der eigentlichen Schottky-Diode parallel und in entgegengesetzter Richtung geschaltet ist. Durch den Spannungsabfall an dieser zweiten Schottky-Diode wird die Flußspannung der Gesamtdiode erhöht, so daß den vorteilhaften Eigenschaften der Schottky-Diode im Vergleich zu einer pn-Diode entgegengewirkt wird.

Aus S.M. Sze, Physics of Semiconductor Devices, Sec. Ed., J. Wiley & Sous, 1981, S. 299 und aus G. Kesel, J. Hammerschmitt, E. Lange, Signalverarbeitende Dioden, Springer-Verlag 1982, Seite 179 ff. ist eine gattungsgemäße Schottky-Diode bekannt. Es sind dort Vorschläge gemacht, wie die obengenannten Nachteile beseitigt werden können. So wird beispielsweise vorgeschlagen, den Halbleiterring mit einem anderen Metall als das Schottky-Metall zu kontaktieren oder einen weiteren Halbleiterbereich in den ringförmigen Halbleiterbereich einzubringen, welcher wiederum vom ersten Dotierungstyp ist. Diese Verbesserungsvorschläge haben jedoch alle den Nachteil, daß zusätzliche technologische Verfahrensschritte, wie Photolithographieprozesse und Diffusionsprozesse erforderlich sind. Bei der Verwendung einer anderen Metallschicht, für welche Aluminium verwendet wird, entsteht zudem der Nachteil, daß die Hochtemperaturfestigkeit der Schottky-Diode herabgesetzt wird, weil das Aluminium leicht in das Halbleitermaterial hineindiffundiert, so daß die Diodeneigenschaften verändert werden. Sowohl zum Kontaktieren mit einem Metall, als auch zum Einbringen eines weiteren Halbleiterbereichs in den ringförmigen Halbleiterbereich sind wegen der dafür erforderlichen kleinen Strukturen komplizierte Photolithographieprozesse erforderlich, die nur bei genügend großen Dimensionen ausführbar sind. Bei dem Einbringen eines zweiten Halbleiterbereichs in den ringförmigen Halbleiterbereich besteht zudem eine Kurzschlußgefahr, wenn der zweite Halbleiterbereich nicht genügend genau positioniert werden kann.

Der Erfindung liegt die Aufgabe zugrunde, eine gattungsgemäße Schottky-Diode und ein Verfahren zum Herstellen einer solchen Schottky-Diode zu schaffen, die ein besseres Flußverhalten aufweist und mit einem weniger aufwendigen Verfahren herstellbar ist.

Diese Aufgabe wird durch eine gattungsgemäße Schottky-Diode gelöst, bei der das Halbleitersubstrat innerhalb der Öffnung der Isolatorschicht eine Vertiefung aufweist, deren Flächen mit der Schottky-Metallschicht bedeckt sind.

Ferner wird die Erfindung durch ein gattungsgemäßes Verfahren gelöst, bei dem in dem Halbleitersubstrat innerhalb der Öffnung der Isolatorschicht eine Vertiefung ausgebildet wird, deren Oberfläche mit der Schottky-Metallschicht bedeckt wird.

Gemäß der Erfindung wird somit eine Schottky-Diode zur Verfügung gestellt, bei der die Schottky-Metallschicht teilweise in das Innere des Halbleitersubstrats gelegt wird, so daß der Metall-Halbleiterübergang in der Vertiefüng liegt. Da die Dotierungsdichte von der Oberfläche des Substrats als Funktion der Tiefe des Substrats stark abnimmt, verläuft der Übergang zwischen dem Schottky-Metall und dem ringförmigen Halbleiterbereich des zweiten Dotierungstyps größtenteils in einem Bereich des ringförmigen Halbleiterbereichs, in dem dessen Dotierungskonzentration erheblich niedriger ist als an der Oberfläche. Somit weist die zweite aus dem Übergang zwischen dem Schottky-Metall und dem ringförmigen Halbleiterbereich gebildete Schottky-Diode D₃, die zu der eigentlichen aus dem Metall-Halbleitersubstrat gebildeten Schottky-Diode D₁ parallel und entgegengesetzt geschaltet ist, einen erheblich kleineren Spannungsabfall auf. Somit wird auch die Flußspannung der gesamten Schottky-Diode erniedrigt.

Bevorzugte Ausführungsbeispiele der Erfindung werden in den Unteransprüchen offenbart.

Gemäß einem vorteilhaften Ausführungsbeispiel der Erfindung ist die Tiefe T der Vertiefung kleiner als die Tiefe t des ringförmigen Halbleiterbereichs. Bei dieser Diode entspricht die Sperrspannung der einer normalen Schottky-Hybrid-Diode, wie sie oben beschrieben ist. Diese Schottky-Diode ist somit für Anwendungen bei hohen Spannungen geeignet und zeigt ein erheblich verbessertes Flußverhalten, da der Flußspannungsabfall reduziert ist.

Gemäß einem zweiten Ausführungsbeispiel der Erfindung ist die Tiefe T der Vertiefung größer als die Tiefe t des ringförmigen Halbleiterbereichs. Bei diesem Ausführungsbeispiel weist die Schottky-Diode ein ähnliches Flußverhalten wie im ersten Ausführungsbeispiel auf. Die Sperrspannung ist bei diesem Ausführungsbeispiel kleiner als bei dem ersten Ausführungsbeispiel kleiner als bei der gewöhnlichen Schottky-Hybrid-Diode. Gegenüber einer normalen Schottky-Diode ohne den ringförmigen Halbleiterbereich weist sie einen geringeren Sperrstrom auf. Dieses Ausführungsbeispiel der Schottky-Diode ist dann vorteilhaft, wenn sehr gute Flußeigenschaften erwünscht sind und gleichzeitig der Sperrstrom bei geringer Sperrspannung gering sein soll.

Vorteilhafterweise kann die Vertiefung durch Ätzen des Halbleitersubstrats erzeugt werden. Dieser Ätzvorgang kann gleichzeitig mit einem Ätzvorgang der Isolatorschicht zur Erzeugung des Schottky-Metall-Kontaktes erfolgen.

Im folgenden wird die Erfindung anhand der Zeichnung näher erläutert.

Es zeigen:
Fig. 1 einen Ausschnitt aus einem ersten Ausführungsbeispiel einer erfindungsgemäßen Schottky-Diode während dem Herstellungsverfahren,
Fig. 2 den Ausschnitt aus dem Ausführungsbeispiel der Schottky-Diode aus Fig. 1 nach weiteren Verfahrensschritten,
Fig. 3 die Schottky-Diode nach Fig. 1 und Fig. 2,
Fig. 4 das Ersatzschaltbild einer erfindungsgemäßen Schottky-Diode und
Fig. 5 ein zweites Ausführungsbeispiel einer erfindungsgemäßen Schottky-Diode.

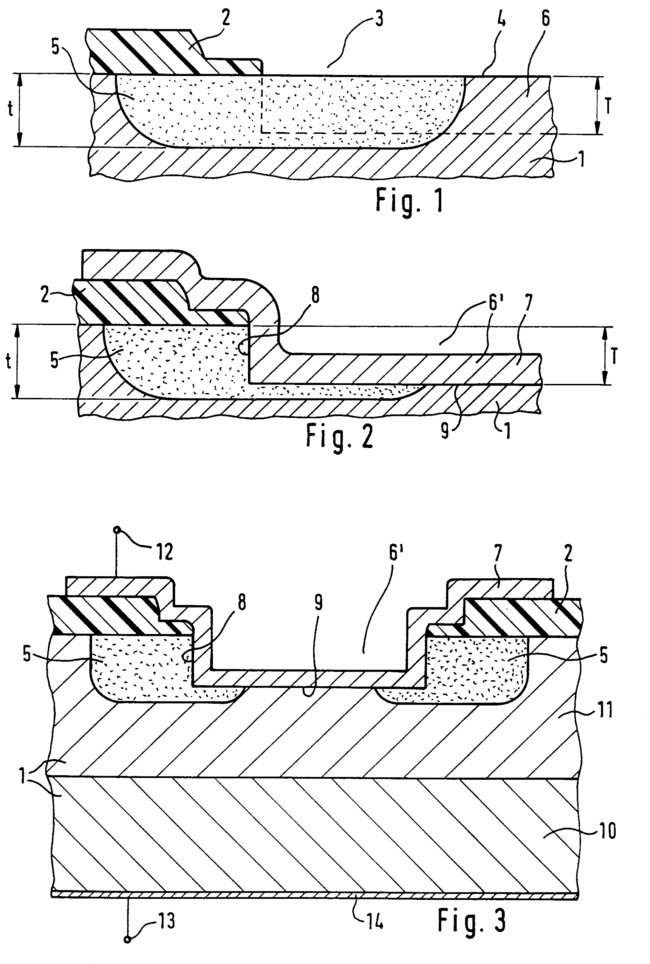

In Fig. 1 ist nach dem erfindungsgemäßen Verfahren in einem Halbleitersubstrat 1 eines ersten Dotierungstyps mit einer ersten Dotierungsdichte eine Isolatorschicht 2 mit einer Öffnung 3 vorgesehen. Durch die Öffnung 3 der Isolatorschicht 2 wird die Oberfläche 4 des Halbleitersubstrats 1 freigelegt. Das Halbleitersubstrat 1 besteht üblicherweise aus einem Halbleiter-Grundsubstrat und einer darauf aufgebrachten Epitaxieschicht, die eine geringere Dotierung als die des Halbleiter-Grundsubstrats aufweist. Der gezeigte Ausschnitt des Halbleitersubstrats 1 entspricht in diesem Fall einer Epitaxieschicht. Beispielsweise handelt es sich dabei um n-leitendes Silizium, wobei das unter der Epitaxieschicht liegende Grundsubstrat stark n-leitendes Silizium ist. Ein ringförmiger Halbleiterbereich 5 ist in das Halbleitersubstrat 1 an dessen Oberfläche eingebracht. Der Querschnitt des Halbleiterbereichs 5 erstreckt sich von einem Bereich unterhalb der Isolatorschicht 2 bis in den Bereich der Öffnung 3 der Isolatorschicht 2, so daß er den Rand der Öffnung 3 umgibt. In der Figur ist ein Ausschnitt der Schottky-Diode auf der linken Seite gezeigt. Der Querschnitt erstreckt sich in entsprechender Symmetrie auf die rechte Seite. Der Halbleiterbereich 5 weist einen zweiten Dotierungstyp mit einer zweiten Dotierungskonzentration auf, die höher als die erste Dotierungskonzentration ist. In dem Beispiel in dem der obere Teil des Halbleitersubstrats 1, also die Epitaxieschicht n-leitend ist, ist der Halbleiterbereich 5 stark p-leitend. Es ist in der Figur ein Bereich 6 des Halbleitersubstrates 1 unterhalb der Öffnung 3 der Isolatorschicht 2 markiert, der aus dem Halbleitersubstrat 1 entfernt werden soll.

In Fig. 2 ist der gleiche Ausschnitt aus der Schottky-Diode wie in der Fig. 1 gezeigt. Es ist dort der Bereich 6 entfernt, so daß eine Vertiefung 6' entsteht. Eine Schottky-Metallschicht 7 ist auf einen Teil der Isolatorschicht 2 und auf den Flächen der Vertiefung 6' aufgebracht. Die Flächen der Vertiefung 6' bestehen hier aus zwei im wesentlichen senkrechten Seitenflächen 8 und einer waagrechten Grundfläche 9.

In Fig. 3 ist ein Querschnitt durch die gesamte Anordnung einer erfindungsgemäßen Schottky-Diode gezeigt. Das Halbleitersubstrat 1 besteht aus einem stark dotierten Halbleiter-Grundsubstrat 10 und aus einer darauf aufgebrachten, schwächer dotierten Epitaxieschicht 11. Die Schottky-Metallschicht 7 überdeckt einen Teil der Isolatorschicht 2 und die Grundfläche 9 und Seitenflächen 8 der Vertiefung 6'. Der ringförmige Halbleiterbereich 5 ist so angeordnet, daß er in einem dem Metall-Isolatorübergang umgebenden Bereich an die Isolatorschicht 2 und an die Schottky-Metallschicht 7 angrenzt. Die Spannungsanschlüsse 12 und 13 werden an die Schottky-Metallschicht 7 und an eine auf die Rückseite des Halbleitersubstrats aufgebrachte Metallschicht 14 angeschlossen.

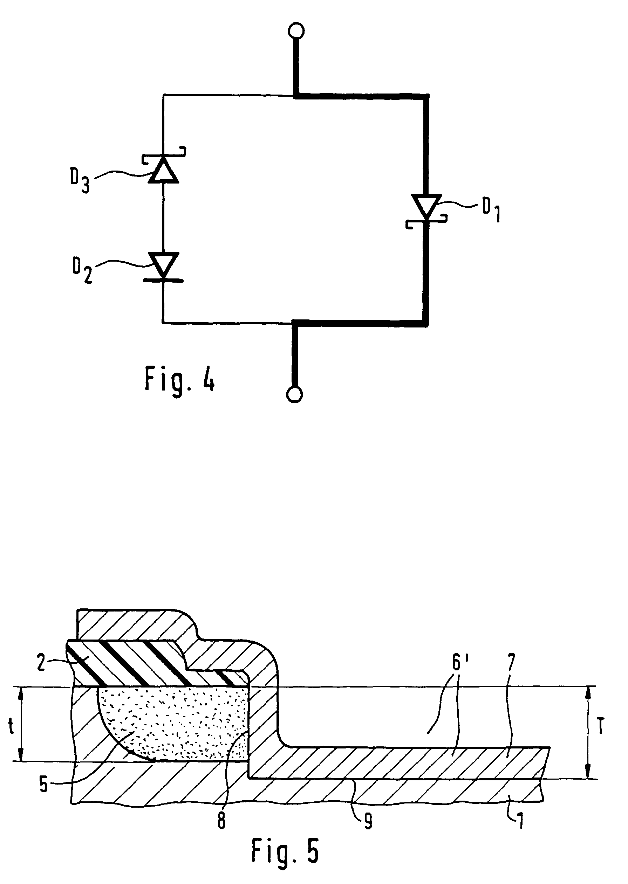

Fig. 4 zeigt ein Ersatzschaltbild einer solchen Schottky-Diode. Darin ist die Diode D₁ die durch den Übergang zwischen der Schottky-Metallschicht 7 und dem Halbleitersubtrat 1 gebildete Schottky-Diode. Die dazu parallel geschalteten Dioden D₂ und D₃ kommen durch den ringförmigen Halbleiterbereich 5 zustande. Dabei entsteht die pn-Diode D₂ durch den Übergang zwischen dem ringförmigen Halbleiterbereich 5 und dem Halbleitersubstrat 1 und die Schottky-Diode D₃ durch den Übergang zwischen der Schottky-Metallschicht 7 und dem ringförmigen Halbleiterbereich 5. Erfindungsgemäß ist der Schottky-Kontakt, d.h. der Kontakt zwischen der Schottky-Metallschicht 7 und dem Halbleitersubstrat 1 und dem ringförmigen Halbleiterbereich 5 in das Innere des Halbleiters gelegt. Da die Konzentration der Dotierung von der Substratoberfläche in das Innere mit zunehmender Tiefe stark abnimmt, wird der Schottky-Kontakt der Schottky-Diode D₃, d.h. der Übergang zwischen der Schottky-Metallschicht 7 und dem ringförmigen Halbleiterbereich 5 in einen Bereich von einer relativ niedrigen Dotierungsdichte im Vergleich zu einer Schottky-Diode, bei der die Schottky-Metallschicht 7 entlang der Substratoberfläche ohne Vertiefung verläuft, gelegt. Dadurch wird erfindungsgemäß der Spannungsabfall der Diode D₃, die zu der eigentlichen Schottky-Diode D₁ in entgegengesetzter Richtung geschaltet ist, erheblich verringert. Hierdurch wird die Flußspannung gegenüber einer Schottky-Diode, deren Schottky-Kontakt entlang der Substratoberfläche verläuft, deutlich verringert, so daß wesentlich bessere Flußeigenschaften entstehen. Aufgrund des Verlaufs der Schottky-Metallschicht 7, insbesondere deren Fläche mit starker Krümmung, innerhalb des ringförmigen Halbleiterbereichs 5 wird durch die Reduktion des Randfeldes der Schottky-Metallschicht 7 eine große Sperrspannung erzielt.

In Fig. 5 ist ein zweites Ausführungsbeispiel einer erfindungsgemäßen Schottky-Diode gezeigt. Die Herstellung erfolgt analog der Herstellung des Ausführungsbeispiels der Schottky-Diode aus den Figuren 1 bis 3. Die Tiefe T der Vertiefung 6' ist im Gegensatz zu dem ersten Ausführungsbeispiel so gewählt, daß sie größer als die Tiefe t des ringförmigen Halbleiterbereichs 5 ist. Bei diesem Ausführungsbeipiel wird der Spannungsabfall an der Schottky-Diode D₃, die durch den Kontakt zwischen der Schottky-Metallschicht 7 und dem ringförmigen Halbleiterbereich 5 zustandekommt noch weiter erniedrigt. Somit hat die gesamte Schottky-Diode in diesem Ausführungsbeispiel eine noch niedrigere Flußspannung und somit ein noch besseres Flußverhalten. Da der Bereich mit starker Krümmung der Schottky-Metallschicht 7 nun wieder in das Halbleitersubstrat 1 gelegt ist, ist die Sperrspannung niedriger als bei der Schottky-Diode gemäß dem Ausführungsbeispiel der Figuren 1 bis 3. Die Sperrspannung liegt jedoch aufgrund der pn-Diode D₂ höher als bei einer gewöhnlichen Schottky-Diode. Zudem ist der Sperrstrom niedriger als bei einer normalen Schottky-Diode. Die Schottky-Diode gemäß dem zweiten Ausführungsbeispiel ist für Anwendungen, die nicht im Hochspannungsbereich liegen, sehr vorteilhaft.

Im folgenden wird das erfindungsgemäße Herstellungsverfahren einer Schottky-Diode anhand dem Ausführungsbeispiel der Figuren 1 bis 3 beschrieben. Auf ein Halbleitersubstrat 1, das aus dem Halbleiter-Grundsubstrat 10 und der darauf aufgebrachten Epitaxieschicht 11 mit niedriger Dotierung vom gleichen Dotierungstyp besteht, wird ein ringförmiger Halbleiterbereich 5 vom entgegengesetzten Dotierungstyp mit hoher Konzentration eingebracht. Auf die Oberfläche des Halbleitersubstrats 1 wird eine Isolatorschicht 2 mit einer Öffnung 3 derart aufgebracht, daß die Oberfläche des Halbleitersubstrats 1 und ein innerer Bereich des ringförmigen Halbleiterbereichs 3 freigelegt werden. Dann wird innerhalb der Öffnung 3 in dem Halbleitersubstrat 1 eine Vertiefung 6' der Tiefe T durch Ätzen erzeugt. Gleichzeitig werden in der Isolatorschicht 2 nicht gezeigte Kontaktöffnungen hergestellt. Dann wird die Schottky-Metallschicht 7 auf die Fläche der Vertiefung 6' und auf einen Teil der Isolatorschicht 2 aufgebracht. Die Rückseite des Halbleitersubstrats 1 wird metallisiert und die Kontaktanschlüsse werden an die Schottky-Metallschicht 7 und die Metallschicht 14 auf der Rückseite des Substrats 1 aufgebracht.

## Patentansprüche

1. Schottky-Diode mit einem Halbleitersubstrat (1) eines ersten Dotierungstyps mit einer ersten Dotierungsdichte, auf dem eine Isolatorschicht (2) mit einer Öffnung (3) vorgesehen ist, und mit einer wenigstens einen Teil der Isolatorschicht (2) und das unter der Öffnung (3) liegende Halbleitersubstrat (1) bedeckenden Schottky-Metallschicht (7), wobei in dem Halbleitersubstrat (1) ein ringförmiger Halbleiterbereich (5) eines zweiten Dotierungstyps mit einer zweiten Dotierungskonzentration, die höher als die erste Dotierungskonzentration ist, vorgesehen ist, der an die Isolatorschicht (2) und die Schottky-Metallschicht (7) in einem den Metall-Isolatorübergang umgebenden Bereich angrenzt, dadurch gekennzeichnet, daß das Halbleitersubstrat (1) innerhalb der Öffnung (3) der Isolatorschicht (2) eine Vertiefung (6') aufweist, deren Fläche (8, 9) mit der Schottky-Metallschicht (7) bedeckt ist.

2. Schottky-Diode nach Anspruch 1, dadurch gekennzeichnet, daß die Tiefe T der Vertiefung (6) kleiner als die Tiefe t des Halbleiterbereichs (5) ist.

3. Schottky-Diode nach Anspruch 1, dadurch gekennzeichnet, daß die Tiefe T der Vertiefung größer als die Tiefe t des Halbleiterbereichs ist.

4. Schottky-Diode nach einem der vorangehenden Patentansprüche, dadurch gekennzeichnet, daß die Vertiefung (6') im wesentlichen senkrechte Seitenflächen (8) und eine waagrechte Grundfläche (9) aufweist.

5. Verfahren zum Herstellen einer Schottky-Diode, bei dem auf einem Halbleitersubstrat (1) eines ersten Dotierungstyps mit einer ersten Dotierungsdichte eine Isolatorschicht (2) mit einer Öffnung (3) vorgesehen wird, eine Schottky-Metallschicht (7) auf wenigstens einen Teil der Isolatorschicht (2) und auf das unter der Öffnung (3) liegende Halbleitersubstrat (1) aufgebracht wird, in das Halbleitersubstrat (1) ein ringförmiger Halbleiterbereich (5) eines zweiten Dotierungstyps mit einer zweiten Dotierungskonzentration, die höher als die erste Dotierungskonzentration ist, eingebracht wird, so daß der Halbleiterbereich (5) an die Isolatorschicht (2) und die Schottky-Metallschicht (7) in einem den Metall-Isolatorübergang umgebenden Bereich angrenzt, dadurch gekennzeichnet, daß in dem Halbleitersubstrat (1) innerhalb der Öffnung (3) der Isolatorschicht (2) eine Vertiefung (6') ausgebildet wird, deren Flache (8, 9) mit der Schottky-Metallschicht (7) bedeckt wird.

6. Verfahren nach Anspruch 5, dadurch gekennzeichnet, daß die Vertiefung mit einer Tiefe T ausgebildet wird, die kleiner als die Tiefe t des Halbleiterbereichs ist.

7. Verfahren nach Anspruch 5, dadurch gekennzeichnet, daß die Vertiefung (6') mit einer Tiefe T ausgebildet wird, die größer als die Tiefe t des Halbleiterbereichs (5) ist.

8. Verfahren nach einem der Ansprüche 5 bis 7, dadurch gekennzeichnet, daß die Oberfläche der Vertiefung mit im wesentlichen senkrechten Seitenflächen (8) und einer waagrechten Grundfläche (9) ausgebildet wird.

9. Verfahren nach einem der Ansprüche 5 bis 8, dadurch gekennzeichnet, daß die Vertiefung (6') durch Ätzen erzeugt wird.
